# DEMANDE DE BREVET EUROPEEN

(11) **EP 0 653 394 A1**
(43) Date de publication de la demande: **17.05.1995**
(21) Numéro de dépôt: 94420305.8
(22) Date de dépôt: 08.11.1994
(51) Int. Cl.: C04B 41/89, C23C 16/26, C23C 16/32

(54) **Traitement de surface de matériau carboné pour rendre adhérent un dépôt ultérieur de diamant et pièces revêtues de diamant obtenues**

(30) Priorité: 12.11.1993 FR 9313746
(71) Demandeur: LE CARBONE LORRAINE, F-92400 Courbevoie (FR)
(72) Inventeur: Bou, Pierre, F-95230 Soisy sous Montmorency (FR); Herbin, Renée, F-45160 Olivet (FR); Rats, David, F-45000 Orleans (FR); Vandenbulcke, Lionel, F-45650 Saint Jean le Blanc (FR)
(74) Mandataire: Mougeot, Jean-Claude

(57) **Abrégé**

Le traitement de surface de matériau carboné (1) est caractérisé en ce qu'on forme sur le matériau carboné (1) une couche de SiC (2) par conversion thermochimique du matériau carboné (1) par un précurseur de Si (4) à une température supérieure à la température de formation, à partir dudit précurseur, d'un intermédiaire gazeux réactif (généralement SiO), de manière à obtenir une couche superficielle (2) permettant un dépôt de diamant adhérent.

Pièces revêtues, au moins localement, de "SiC / diamant".

## Description

### DOMAINE DE L'INVENTION

L'invention concerne le domaine des matériaux carbonés et des traitements destinés à modifier l'état de surface de ces matériaux, en particulier pour les rendre adhérents à d'autres matériaux, en particulier le diamant.

### ART ANTERIEUR

L'homme du métier connaît l'intérêt d'obtenir un matériau carboné recouvert de diamant, compte tenu des propriétés remarquables du diamant, c'est à dire essentiellement, sa dureté, son faible coefficient de frottement, sa conductivité thermique élevée, sa relative stabilité thermique et chimique etc...

On sait obtenir industriellement des dépôts de diamant, en utilisant la technique de dépôt chimique en phase vapeur (DCPV en abrégé), à l'aide de plasma alimenté en gaz porteur de carbone et en hydrogène, mais il n'est pas possible de déposer du diamant sur un matériau carboné sans détruire simultanément, au moins en partie, le matériau carboné lui-même. En effet, les gaz utilisés par la DCPV réagissent plus vite avec le substrat carboné qu'il ne se forme une couche de diamant assez dense pour faire barrière.

On a donc déjà envisagé de déposer sur un matériau carboné une couche protectrice d'accrochage, couche protectrice pour le matériau carboné et couche d'accrochage pour le dépôt de diamant.

Ainsi, on a déjà revêtu un matériau carboné d'une couche de SiC, soit amorphe, soit cristallisé, et dans tous les cas il n'a pas été possible d'obtenir un dépôt de diamant d'adhérence suffisante.

### PROBLEME POSE

La demanderesse a constaté qu'il n'existait pas de procédé pour obtenir des pièces carbonées à dépôt de diamant adhérent en surface, en particulier pour obtenir des pièces de dimensions relativement grandes, par exemple des joints destinés à assurer une étanchéité dynamique.

En effet, aucun des procédés connus ne permet d'obtenir une adhérence satisfaisante.

### DESCRIPTION DE L'INVENTION

Selon l'invention, le traitement de surface d'un matériau carboné vise à recouvrir ledit matériau carboné d'une couche superficielle apte à servir de substrat pour un dépôt ultérieur de diamant par DCPV, et est caractérisé en ce que, de manière à obtenir un dépôt de diamant adhérent à ladite couche superficielle, on forme sur ledit matériau carboné une couche de SiC par conversion thermochimique du matériau carboné avec un réactif contenant du Si, choisi parmi le Si lui-même ou un précurseur de Si, à une température supérieure, soit à la température de fusion de Si dans le cas où Si est utilisé, soit, si ledit précurseur de Si est utilisé, à la température de réaction dudit précurseur de Si avec ledit matériau carboné, directement ou par formation d'un intermédiaire gazeux réactif contenant Si.

La demanderesse a eu l'idée d'explorer une voie qui semblait pourtant peu prometteuse compte tenu des résultats obtenus par dépôt de SiC par les méthodes classiques de DCPV : quelles que soient les conditions expérimentales, et quelles que soient la structure cristalline du SiC déposé, qu'il soit bien cristallisé ou relativement amorphe, dans tous les cas le dépôt de SiC sur substrat carboné ne permettait pas d'obtenir un dépôt de diamant suffisamment adhérent à la couche de SiC.

L'utilisation d'une couche de SiC comme couche intermédiaire, semblait donc peu encourageante jusqu'à ce que la demanderesse persiste dans l'exploration de cette voie vers une direction différente, à savoir la formation de SiC par conversion thermochimique d'un substrat de graphite.

La demanderesse a essayé de comprendre en quoi la couche de SiC obtenue selon l'invention différait des diverses couches de SiC (amorphes ou cristallisées) obtenues classiquement par DCPV.

Elle a noté les différences suivantes :
* la porosité des couches de SiC obtenues selon l'invention est supérieure à celle des couches de SiC obtenues par DCPV.
* les couches de SiC obtenues selon l'invention contiennent du carbone libre contrairement aux couches obtenues par DCPV (généralement stoechiométriques).
* les couches obtenues selon l'invention, contrairement à celles obtenues par DCPV, sont d'épaisseur importante (> 100 µm) et présentent un gradient de transformation permettant de passer de façon continue du SiC, quasiment pur en surface, au graphite.

Ces différences sont sans doute à l'origine de la bonne adhérence des dépôts de diamant par DCPV, la demanderesse n'ayant pu guère aller au-delà de ces présomptions.

### DESCRIPTION DES FIGURES

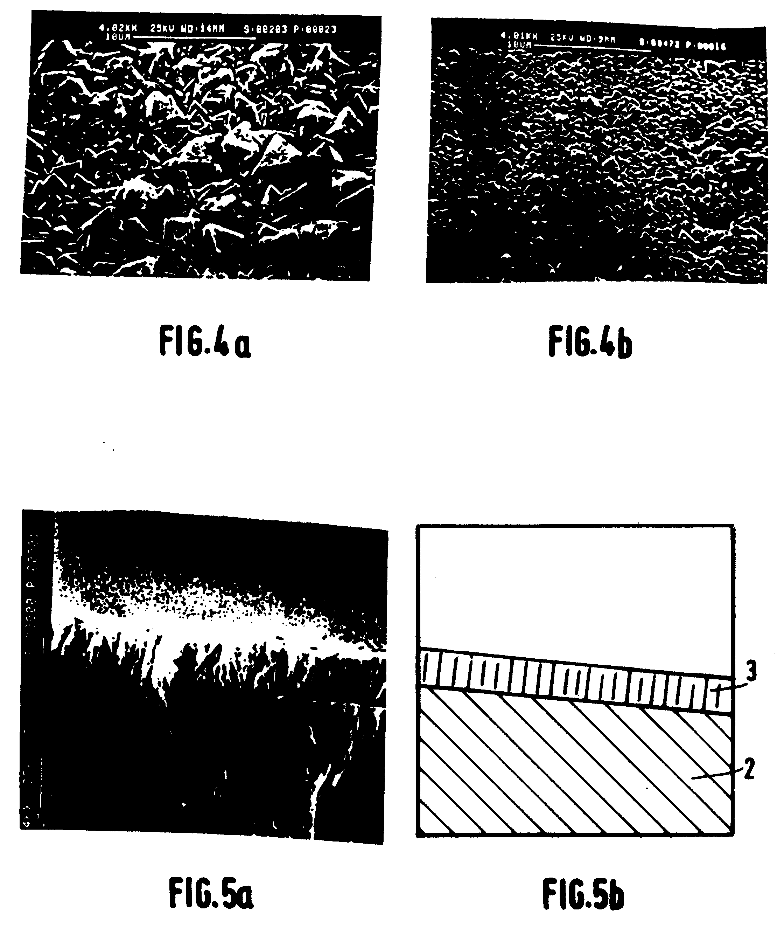

Toutes les figures, à l'exception de la figure 4a, correspondent à l'invention.

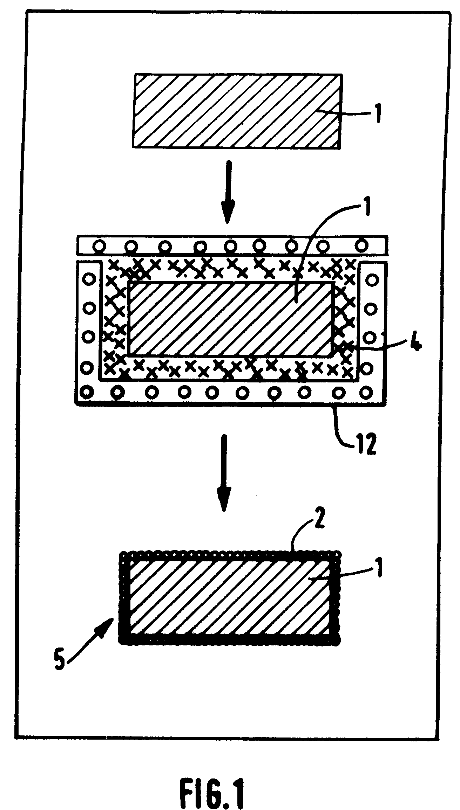

La figure 1 décrit schématiquement le procédé de conversion thermochimique utilisé pour obtenir une couche de SiC (2) selon l'invention sur un matériau carboné (1) : le matériau carboné à traiter (1) est recouvert de poudre de précurseur de Si (4), le tout étant placé dans une enceinte chauffée (12) permettant de décomposer le précurseur et de former la couche de SiC.

A noter que le matériau carboné à traiter n'a pas à être recouvert de précurseur puisqu'il importe seulement que le matériau carboné soit en contact avec l'intermédiaire gazeux réactif comprenant Si et formé à partir du précurseur.

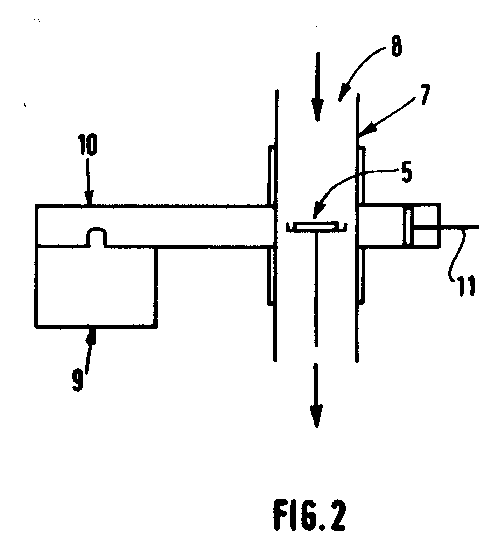

La figure 2 représente schématiquement en coupe un dispositif de DCPV assisté par micro-ondes permettant le dépôt d'une couche de diamant sur une pièce de graphite recouverte d'une couche de SiC selon l'invention, désignée par le repère (5). Le repère (7) désigne le tube de quartz, relié à une pompe à vide (non représentée), dans lequel a lieu le dépôt de diamant. Le repère (8) désigne l'entrée des gaz. Le repère (9) désigne le magnétron et le repère (11) le piston court-circuit.

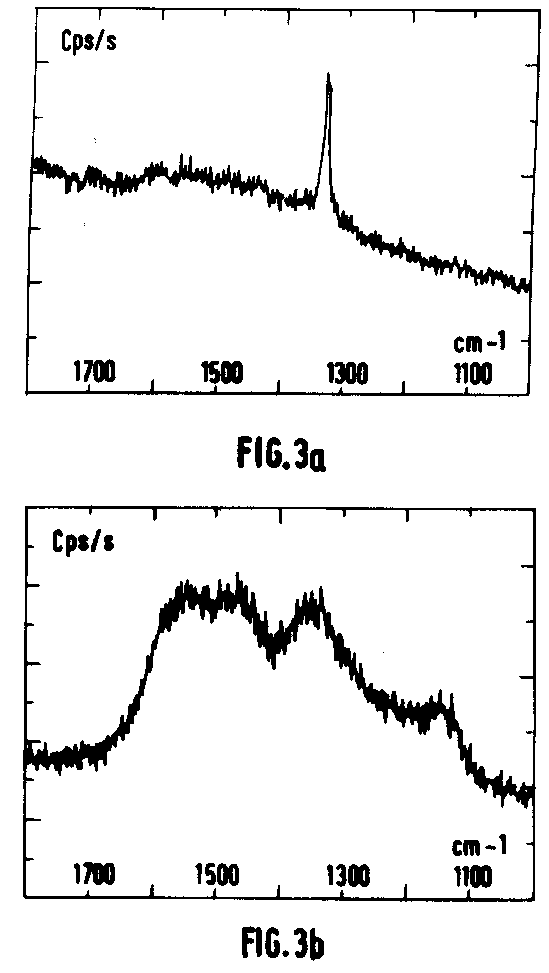

Les figures 3a et 3b sont des enregistrements en spectroscopie RAMAN de deux dépôts typiques de diamant adhérents au matériau carboné préalablement converti superficiellement en SiC (5) selon l'invention.

La spectroscopie RAMAN donne des renseignements sur la qualité cristalline du diamant déposé (finesse du pic à 1332 cm⁻¹ caractéristique du carbone diamant) et sur la quantité de carbone non-diamant incorporée dans le dépôt par l'importance des bandes situées à 1350, 1450 et 1575 cm⁻¹.

La figure 3a correspond à un dépôt riche en diamant hautement cristallisé, alors que la figure 3b correspond à un dépôt mixte diamant + carbone de type "sphérulitique".

Les figures 4a et 4b sont des photographies au microscope électronique à balayage d'un dépôt de diamant (échelle de 10 µm représentée) sur substrat (5), selon l'art antérieur à la figure 4a et, selon l'invention, à la figure 4b.

Les figures 5a et 5b représentent une coupe d'une pièce (6) de graphite recouverte de SiC selon l'invention et recouverte de diamant.

La figure 5a est une photographie au microscope électronique (échelle de 10 µm représentée) schématisée à la figure 5b pour faciliter sa compréhension.

### DESCRIPTION DETAILLEE DE L'INVENTION

Les précurseurs de Si (4) qui conviennent selon l'invention sontchoisis : parmi les mélanges connus pour générer SiO, parmi les composés hydrogénés de Si, parmi les halogénures de Si, hydrogénés ou non, et parmi les polymères contenant Si conduisant par décomposition thermique à Si, à SiO ou à un halogénure de Si.

De préférence, on choisit, parmi les mélanges connus pour générer SiO, les mélanges de SiO₂ + C (toute matière carbonée), de SiO₂ + Si ou de SiC + SiO₂.

Chacun de ces mélanges génère du SiO, intermédiaire gazeux qui réagit avec le graphite de la pièce à traiter pour former, avec dégagement de CO, une couche superficielle de SiC.

Les conditions précises de la conversion thermochimique dépendent du choix du précurseur et de la pression, et sont fixées par les données de la thermodynamique.

On choisira typiquement une température supérieure à 1500°C pour que la formation de la couche de SiC soit obtenue en un temps raisonnable sur la plan industriel, typiquement en 2 h.

De préférence, on choisit la durée et la température de ladite conversion thermochimique de manière à obtenir une couche de SiC d'épaisseur moyenne comprise entre 0,1 et 2 mm.

Par ailleurs, avant de commencer le dépôt de diamant par DCPV, la demanderesse a observé qu'il était préférable de polir ou d'ensemencer, à la pâte diamantée, ledit matériau carboné revêtu de SiC (5), de manière à favoriser la nucléation du diamant.

Le traitement de surface selon l'invention s'applique à tous les types de matériaux carbonés, y compris les pyrocarbones et les produits carbonés issus de carbonisation de résines, de brais divers, le matériau étant de préférence massif, mais pouvant être également à l'état divisé.

De préférence, ledit matériau carboné (1) est du graphite.

Un autre objet de l'invention est constitué par les pièces carbonées recouvertes d'une couche de SiC selon l'invention (repère 5), et bien sûr, plus particulièrement les pièces de graphite ainsi recouvertes.

Un troisième objet de l'invention est constitué par les pièces finales (repère 6) obtenues après dépôt de diamant par DCPV sur les pièces précédentes (5) obtenues selon l'invention. Ces pièces composite sont typiquement constituées d'une masse de matériau carboné recouverte d'une couche de SiC d'épaisseur typiquement comprise entre 0,1 et 2 mm, elle-même recouverte d'une couche de diamant d'épaisseur typiquement comprise entre 0,5 et 300 µm.

Selon les conditions de dépôt du diamant, on peut obtenir une couche soit riche en diamant cristallisé (voir figures 3a et 4b), soit comprenant un mélange de diamant et de carbone de type sphérulitique (voir figure 3b).

Un dernier objet de l'invention, lié à la difficulté de braser le diamant, est constitué par des pièces, en matériau non carboné, revêtues, au moins localement, d'un matériau composite "SiC / diamant", la couche de SiC étant liée, typiquement par brasure, au matériau non carboné.

Pour cela, selon l'invention, on réalise d'abord un dépôt de diamant sur du graphite transformé superficiellement en SiC, puis on oxyde sélectivement le graphite de manière à éliminer le graphite et à obtenir un matériau composite "SiC / diamant" qui pourra ensuite être facilement assemblé (notamment brasé) à un support choisi.

Ceci présente un grand intérêt quand on veut disposer localement d'un revêtement de diamant sur une pièce trop grande pour être intoduite dans un réacteur de CVD ou sur une pièce (en acier par exemple) qui ne supporterait pas la température de dépôt. En effet, les solutions existantes pour obtenir ce type de pièces sont délicates à mettre en oeuvre et coûteuses alors qu'il est beaucoup plus simple de mettre en oeuvre l'invention en brasant le SiC.

On peut ainsi fabriquer des pièces présentant localement une zone résistant à l'usure (outils de coupe par exemple).

Ces pièces peuvent être choisies dans le groupe constitué par : un joint de friction, un palier, un coussinet.

### EXEMPLES

Dans tous ces exemples, le matériau de départ (1) a été un graphite standard du commerce (référence 2114 de la Société CARBONE LORRAINE).

Les exemples 1 et 2 sont selon l'art antérieur, tous les autres exemples sont selon l'invention.

### EXEMPLE 1

On a réalisé par DCPV classique un dépôt de SiC (2) sur un substrat de graphite (1) de 15 x 10 mm et de 4 mm d'épaisseur.

La technique de DCPV classique comprend typiquement la décomposition de méthyltrichlorosilane (MTS) au-dessus de 850°C en présence d'hydrogène.

On a obtenu, typiquement en 30 min, une couche de 25 µm de SiC.

On a fait 2 essais en faisant varier les conditions opératoires, et on a obtenu deux pièces dont les couches de SiC présentaient des différences de cristallinité suffisantes pour représenter typiquement une couche de SiC cristallisé (produit 1a) et une couche de SiC amorphe (produit 1b).

On a ensuite ensuite poli ces produits 1a et 1b de la manière suivante : dans un premier temps, prépolissage jusqu'à la granulométrie 1200, puis ensuite polissage à la pâte diamantée.

### EXEMPLE 2

On a déposé du diamant par DCPV sur les deux produits 1a et 1b polis de l'exemple 1, et de dimensions 15x10x4 mm .

Conditions de dépôt :
* pression totale des gaz : 1,33 kPa
* température du substrat (produit 1a,1b) : 825°C
* puissance micro-onde : 1,1 kW (Magnétron à 2,45GHz)
* mélange gazeux : CH4/H2/O2/Ar
* durée de dépôt : 2 h

Le produit final 2a obtenu à partir du produit 1a a été représenté à la figure 4a.

On a observé un écaillement partiel de la couche de diamant dès la sortie du réacteur.

Le produit 1b a été traité dans les mêmes conditions, sauf une pression totale de 0,67 kPa. Dans ce cas, en sortie de réacteur, la couche de diamant était totalement décollée.

### EXEMPLE 3

On a préparé des pièces de graphite recouvertes de SiC (5) selon l'invention par le procédé de conversion thermochimique (appelé parfois "pack-cémentation") décrit à la figure 1 à partir de pièces de graphite de départ (1) de 16 mm de diamètre et 7 mm d'épaisseur.

Comme précurseur de Si, on a utilisé un mélange de SiO₂+ C.

La conversion thermochimique a eu lieu à 1550 °C. On a ainsi obtenu des pièces de graphite recouvertes d'une couche de SiC (5).

Pour une durée de conversion de 2 h, on a obtenu une pièce de graphite recouverte d'une couche d'épaisseur de 1 mm (produit 3a).

On a réalisé d'autres essais de durée différente et on a obtenu des pièces (5) ayant une couche de SiC d'épaisseur globalement comprise entre 0,1 et 2 mm.

Toutes ces pièces ont été polies comme décrit à l'exemple 1.

### EXEMPLE 4

On a effectué un dépôt de diamant par DCPV sur le produit 3a poli de l'exemple 3.

Conditions de dépôt :
* pression totale des gaz : 0,67 kPa
* température : 550°C
* puissance micro-onde (en mode pulsé) : 580 W
* mélange gazeux : CO/H2/O2
* durée du dépôt : 8 h

Résultats : on a obtenu une couche de diamant de 2,5 µm d'épaisseur parfaitement adhérente à son substrat. La figure 4b est une photographie montrant la surface diamantée .

Ces résultats sont surprenants car, par ailleurs, l'adhérence d'un dépôt de diamant est connue pour être d'autant plus faible que le dépôt est réalisé à basse pression et basse température.

### EXEMPLE 5

On a effectué un dépôt de diamant par DCPV sur le produit 3a poli de l'exemple 3.

Conditions de dépôt :
* pression totale des gaz : 0,67 kPa
* température : 875°C
* puissance micro-onde (en mode pulsé) : 1,1 kW
* mélange gazeux : CO/H2/O2
* durée du dépôt : 2 h

Résultats : on a obtenu une couche de diamant de 5 µm d'épaisseur parfaitement adhérente à son substrat.

### EXEMPLE 6

On a effectué un dépôt de diamant par DCPV sur le produit 3a polide l'exemple 3.

Conditions de dépôt :
* pression totale des gaz : 4 kPa
* température : 880°C
* puissance micro-onde (en mode pulsé) : 1,1 kW
* mélange gazeux : CO/H2/O2
* durée du dépôt : 2 h

Résultats : on a obtenu une couche de diamant de 6 µm d'épaisseur parfaitement adhérente à son substrat.

Le diagramme RAMAN correspondant à la couche de diamant est à la figure 3a. Il montre la présence d'une couche de diamant relativement pure et bien cristallisée.

### EXEMPLE 7

On a effectué un dépôt de diamant par DCPV sur le produit 3a poli de l'exemple 3.

Conditions de dépôt :
* pression totale des gaz : 0,67 kPa
* température : 935°C
* puissance micro-onde (en mode pulsé) : 1,1 kW
* mélange gazeux : CO/H2
* durée du dépôt : 2 h

Résultats : on a obtenu une couche de diamant de 7 µm d'épaisseur parfaitement adhérente à son substrat.

Le diagramme RAMAN correspondant à la couche de diamant est à la figure 3b. Il montre la présence d'une couche de diamant comprenant une plus grande quantité de carbone de type sphérulitique, par rapport au diagramme de la figure 3a.

### EXEMPLE 8

Dans cet exemple, le produit 3a de l'exemple 3 n'a pas été poli comme aux exemples 1 et 3. La surface du produit 3a a été simplement nettoyée aux ultra-sons puis ensemencée par la pâte diamantée de façon à induire la nucléation du diamant.

Puis, on a effectué un dépôt de diamant par DCPV sur ce produit non poli.

Conditions de dépôt :
* pression totale des gaz : 2,63 kPa
* température : 865°C
* puissance micro-onde (en mode pulsé) : 1,1 kW
* mélange gazeux : CO/H2/O2
* durée du dépôt : 2 h

On obtient un dépôt riche en carbone sphérulitique, comme à l'exemple 7, parfaitement adhérent à son substrat de SiC.

### APPLICATIONS

L'invention trouve tout son intérêt pour la fabrication de certains types de pièces (pièces en graphite recouvertes d'une couche composite SiC/ diamant), en particulier des bagues pour garnitures d'étanchéité, joints de friction, paliers, coussinets, etc...

Par ailleurs, l'invention permet de recouvrir localement un support (typiquement par brasage) d'une couche composite SiC/diamant (obtenue par oxydation sélective du graphite d'une pièce graphite/SiC/ diamant), ce qui élargit considérablement le champ de l'invention, en particulier aux outils en acier.

### AVANTAGES DE L'INVENTION

L'invention est d'un grand intérêt technique et économique puisqu'elle ouvre la voie à la production industrielle fiable de pièces composites massivement en carbone (ou en graphite) revêtues de SiC, lui-même revêtu d'une couche mince de diamant totalement adhérente à son substrat de SiC (composite Carbone (ou Graphite)/SiC/Diamant). En effet, jusqu'à présent, il était impensable de commercialiser ce type de pièces, le fabricant étant incapable de garantir la présence d'un dépôt adhérent de diamant sur les pièces fabriquées.

L'invention permet donc d'élargir considérablement les possibilités techniques, déjà grandes, des matériaux à base de carbone ou de graphite, en particulier dans le domaine de la friction et plus particulièrement des joints dynamiques.

Par ailleurs, l'invention permet de revêtir d'une couche composite SiC / diamant tout support (notamment l'acier) sur lequel on peut fixer une couche de SiC (notament par brasage).

## Revendications

**1 -** Traitement de surface d'un matériau carboné (1) pour le recouvrir d'une couche superficielle apte à servir de substrat pour un dépôt ultérieur de diamant (3) par DCPV, caractérisé en ce que, de manière à obtenir un dépôt de diamant (3) adhérent à ladite couche superficielle, on forme sur ledit matériau carboné (1) une couche dé SiC (2) par conversion thermochimique du matériau carboné (1) avec un réactif contenant du Si, choisi parmi le Si lui-même ou un précurseur de Si (4), à une température supérieure, soit à la température de fusion de Si dans le cas où Si est utilisé, soit à la température de réaction dudit précurseur de Si (4) avec ledit matériau carboné (1), directement ou par la formation d'un intermédiaire gazeux réactif contenant Si.

**2 -** Traitement selon la revendication 1 dans lequel ledit précurseur de Si (4) est choisi : parmi les mélanges connus pour générer SiO, parmi les composés hydrogénés de Si, parmi les halogénures de Si, hydrogénés ou non, et parmi les polymères contenant Si conduisant par décomposition thermique à Si, à SiO ou à un halogénure de Si.

**3 -** Traitement selon la revendication 2 dans lequel on choisit de préférence, parmi les mélanges connus pour générer SiO, SiO₂ + Si, SiO₂ + SiC, ou SiO₂ + C.

**4 -** Traitement selon une quelconque des revendications 1 à 3 dans lequel la durée et la température de ladite conversion thermochimique sont choisies de manière à obtenir une couche de SiC d'épaisseur moyenne comprise entre 0,1 et 2 mm.

**5 -** Traitement selon une quelconque des revendications 1 à 4 dans lequel ledit matériau carboné revêtu de SiC (5) est poli ou ensemencé avant dépôt de diamant par DCPV, de manière à favoriser la nucléation du diamant.

**6 -** Traitement selon une quelconque des revendications 1 à 5 dans lequel ledit matériau carboné (1) est du graphite.

**7 -** Pièce de graphite recouverte d'une couche de SiC, d'épaisseur comprise entre 0,1 et 2 mm, obtenue selon le traitement de la revendication 6.

**8 -** Pièce (6) obtenue par dépôt de diamant (DCPV) sur une pièce (5) selon la revendication 7, la couche de diamant (3) ayant une épaisseur comprise entre 0,5 et 300 µm.

**9 -** Pièce (6) selon la revendication 8 dans laquelle ladite couche de diamant (3) comprend du carbone de type sphérulitique.

**10 -** Pièce (6) selon une quelconque des revendications 8 et 9 choisie parmi le groupe constitué par : un joint de friction, un palier, un coussinet.

**11 -** Matériau composite "SiC / diamant" obtenu par le traitement selon une quelconque des revendications 1 à 6, ledit traitement étant suivi d'une oxydation sélective dudit matériau carboné.

**12 -** Pièce revêtue, au moins localement, d'une couche composite "SiC / diamant" du matériau de la revendication 11, typiquement un outil en acier présentant localement une zone résistant à l'usure.
